# EUROPEAN PATENT APPLICATION

(11) **EP 3 624 354 A1**
(43) Date of publication of application: **18.03.2020**
(21) Application number: 18798920.7
(22) Date of filing: 02.04.2018
(51) Int. Cl.: H04B 1/38, H04B 7/15

(54) **WIRELESS RELAY DEVICE**

(30) Priority: 10.05.2017 JP 2017093846
(71) Applicant: Fujikura Ltd., Tokyo 135-8512 (JP)
(72) Inventor: IWATA, Koichiro, Sakura-shi Chiba 285-8550 (JP)
(74) Representative: Plasseraud IP
(86) International application number: PCT/JP2018/014115
(87) International publication number: WO 2018/207500

(57) **Abstract**

An object of an aspect of the present invention is to configure a radio relay device, which is applied to radio communication carried out with use of a microwave or a millimeter wave, such that a time delay which may occur in association with radio communication relay is reduced while a transmission loss of a radio wave is prevented or reduced. A radio IC (31) and a radio IC (32) are connected with each other via a wire (41) on a substrate (11) so that a baseband signal is transmitted via the wire (41).

## Description

### Technical Field

The present invention relates to a radio relay device.

### Background Art

For example, Patent Literatures 1 and 2 each disclose a radio relay device for achieving a longer communication distance in radio communication by allowing a radio wave transmitted from a source (e.g., a base station) to be received even at a destination (e.g., a terminal) present at a place which is less visible (or invisible) from the source.

Fig. 1 of Patent Literature 1 illustrates a radio relay device for allowing radio communication between a base station and a terminal (a terminal device described in Patent Literature 1) which are separated from each other by a wall which transmits therethrough no radio wave. The radio relay device disclosed in Patent Literature 1 is configured such that a coupled antenna and a relay antenna are connected with each other via metal cables (a coaxial cable and a ribbon feeder). According to the radio relay device disclosed in Patent Literature 1, the metal cables are provided so as to extend over both sides of the wall, and the coupled antenna and the relay antenna are provided in a base station side space and a terminal side space, respectively, of two spaces which are separated by the wall. In a case where the coupled antenna is disposed so as to be coupled with a base antenna of the base station and the relay antenna is disposed so as to be coupled with the terminal, the radio relay device disclosed in Patent Literature 1 allows radio transmission between the base station and the terminal which are separated by the wall.

For example, Fig. 1 of Patent Literature 2 illustrates a radio relay device for allowing radio communication between an outdoor base station and an indoor terminal (a terminal station described in Patent Literature 2). The radio relay device disclosed in Patent Literature 2 includes two antennas, two radio circuits, two baseband circuits, two control sections, and one DPRAM. According to the radio relay device disclosed in Patent Literature 2, in a case where one of the antennas receives a radio wave from the base station, a radio signal superimposed on the radio wave is converted into a baseband signal with use of one of the radio circuits first, and then the baseband signal is decoded into a data signal with use of one of the baseband circuits. Thereafter, the data signal is encoded into a baseband signal with use of the other one of the baseband circuits, the baseband signal is converted into a radio signal with use of the other one of the radio circuits, and a radio wave on which the radio signal is superimposed is transmitted to the terminal via the other one of the antennas. The radio relay device disclosed in Patent Literature 2 thus can relay radio communication between the base station and the terminal.

### Citation List

### [Patent Literatures]

[Patent Literature 1]
   Japanese Patent Application Publication Tokukai No. 2002-185381 (Publication Date: June 28, 2002)
[Patent Literature 2]
   Japanese Patent Application Publication Tokukai No. 2005-101986 (Publication Date: April 14, 2005)

### Summary of Invention

### Technical Problem

According to the radio relay device disclosed in Patent Literature 1, in a case where a radio wave to be relayed has a higher frequency, a greater transmission loss of a radio wave occurs in the metal cables. Thus, in a case where the radio relay device disclosed in Patent Literature 1 is applied to radio communication carried out with use of a microwave or a millimeter wave, a radio wave may be relayed with greatly reduced efficiency, or it may be difficult for the base station and the terminal device to communicate with each other.

The radio relay device disclosed in Patent Literature 2 requires (i) a decoding process for decoding a baseband signal into a data signal and (ii) an encoding process for encoding the data signal into a baseband signal. The decoding process and the encoding process impose a heavy load on the radio relay device. Thus, the radio relay device disclosed in Patent Literature 2 has a problem such that a long time delay occurs in association with radio communication relay. Furthermore, the decoding process and the encoding process, which impose a heavy load on the radio relay device, also lead to an increase in cost of a circuit (IC) constituting the radio relay device.

An aspect of the present invention has been made in view of the problems, and an object of an aspect of the present invention is to configure a radio relay device, which is applied to radio communication carried out with use of a microwave or a millimeter wave, such that a time delay which may occur in association with radio communication relay is reduced while a transmission loss of a radio wave is prevented or reduced. Furthermore, a secondary object of an aspect of the present invention is to prevent or reduce an increase in cost of a circuit (IC) constituting the radio relay device.

### Solution to Problem

In order to attain the object, a radio relay device in accordance with an aspect of the present invention includes: a substrate; a receiving antenna, provided on the substrate, for converting a first electromagnetic wave into a first radio frequency (RF) signal; a first radio integrated circuit (IC), provided on the substrate, for converting, into a baseband signal, the first RF signal which has been obtained via the receiving antenna; a second radio IC, provided on the substrate, for converting, into a second RF signal, the baseband signal which has been obtained by the first radio IC; and a transmitting antenna, provided on the substrate, for converting, into a second electromagnetic wave, the second RF signal which has been obtained by the second radio IC, the first radio IC and the second radio IC being connected with each other via a wire on the substrate so that the baseband signal is transmitted via the wire.

### Advantageous Effects of Invention

An aspect of the present invention makes it possible to configure a radio relay device, which is applied to radio communication carried out with use of a microwave or a millimeter wave, such that a time delay which may occur in association with radio communication relay is reduced while a transmission loss of an electric signal is prevented or reduced.

### Brief Description of Drawings

Fig. 1 is a plan view and a side view each schematically illustrating a configuration of a radio relay device in accordance with Embodiment 1 of the present invention.
   (a) and (b) of Fig. 2 are each a side view illustrating a state in which the radio relay device illustrated in Fig. 1 is bent.
Fig. 3 is a plan view schematically illustrating a configuration of a radio relay device in accordance with Embodiment 2 of the present invention.
Fig. 4 is a conceptual diagram showing an example of use of a radio relay device in accordance with an embodiment of the present invention.

### Description of Embodiments

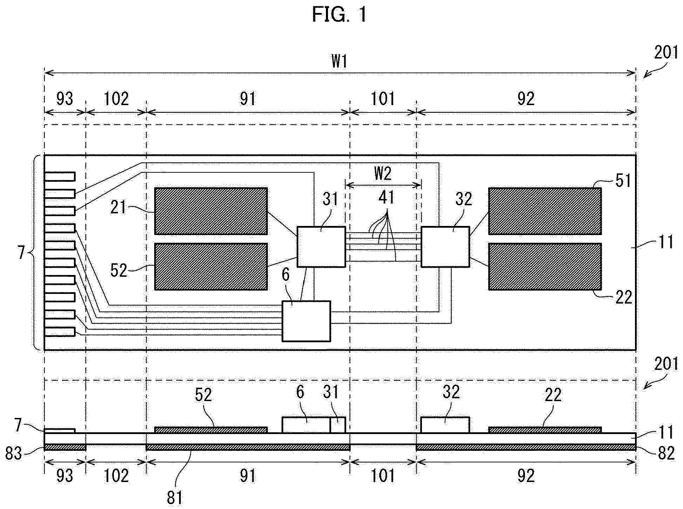

Embodiments of the present invention are described below with reference to Figs. 1 through 4.

### [Embodiment 1]

Fig. 1 is a plan view and a side view (obtained in a case where the plan view is viewed from bottom to above) each schematically illustrating a configuration of a radio relay device 201 in accordance with Embodiment 1 of the present invention. The radio relay device 201 illustrated in Fig. 1 includes a substrate 11, receiving antennas 21 and 22, radio ICs 31 and 32, a plurality of wires 41, transmitting antennas 51 and 52, a control IC 6, an edge connector 7, and reinforcing plates 81 to 83. The radio relay device 201 can include, for example, a capacitor (not illustrated), a resistor (not illustrated), and a quartz oscillator (not illustrated) which are provided around the radio IC 31 or the radio IC 32 and each of which is an electronic component necessary for driving of the radio ICs 31 and 32.

The substrate 11 is a substrate on which to mount various members constituting the radio relay device 201. The substrate 11 is a flexible substrate whose base material is a liquid crystal polymer (LCP). Since the base material of the substrate 11 is an LCP, a loss, caused by the substrate 11, in electric signal and/or RF signal can be prevented or reduced in a case where the radio relay device 201 is used in radio communication in a several GHz band to several ten (e.g., 60) GHz band. The substrate 11 has a front surface on which the receiving antennas 21 and 22, the radio ICs 31 and 32, the plurality of wires 41, the transmitting antennas 51 and 52, the control IC 6, and the edge connector 7 are provided. The substrate 11 has a back surface on which the reinforcing plates 81 to 83 are provided. Assume here that a length of the substrate 11, as measured in a longer side direction thereof, is W1. Note that the substrate 11 has a multilayer structure, though not illustrated. The base material of the substrate 11 is not limited to an LCP but can be, for example, a polyimide. Furthermore, the substrate 11, which is a single plate in Fig. 1, can alternatively be obtained by combining a plurality of plates.

The receiving antennas 21 and 22 are each provided on the substrate 11 in a form of a pattern made of metal. The receiving antennas 21 and 22 each receive a first electromagnetic wave and convert, into a first RF signal, the first electromagnetic wave received. The first RF signal is, for example, a signal belonging to a millimeter wave band and having a frequency of 30 GHz to 300 GHz. For simple illustration, in Fig. 1, the receiving antennas 21 and 22 are each a member which is rectangular when viewed from above. Note, however, that neither of the receiving antennas 21 and 22 is particularly limited in shape. Note also that the receiving antennas 21 and 22 each can be provided on not only the front surface of the substrate 11 but also the back surface of the substrate 11 or an inner layer of the substrate 11.

The radio ICs 31 and 32 are each mounted on the substrate 11. The radio IC 31, which is electrically connected with the receiving antenna 21, demodulates the first RF signal obtained via the receiving antenna 21 and converts, into a baseband signal, the first RF signal demodulated. The radio IC 32, which is electrically connected with the receiving antenna 22, demodulates the first RF signal obtained via the receiving antenna 22 and converts, into a baseband signal, the first RF signal demodulated. As such a baseband signal, it is possible to employ, for example, a differential modulated signal having a frequency of several GHz (e.g., 1 GHz to 3 GHz) and subjected to IQ modulation.

The plurality of wires 41 are provided on the substrate 11. The plurality of wires 41 are each provided in a form of a pattern made of metal (e.g., copper, copper plated with nickel, copper plated with gold, or copper plated with nickel and gold). The radio IC 31 and the radio IC 32 are electrically connected with each other via the plurality of wires 41, and the baseband signal obtained by the radio IC 31 and the baseband signal obtained by the radio IC 32 are transmitted via the plurality of wires 41. The plurality of wires 41 is, for example, a (so-called GSSG) coplanar line in which a ground, a signal line, a signal line, and a ground are provided in this order on a substrate or an inner layer of the substrate. Alternatively, the plurality of wires 41 is, for example, a plurality of coaxial cables. Either the baseband signal obtained by the radio IC 31 or the baseband signal obtained by the radio IC 32 is transmitted via each of the plurality of wires 41 at a speed of, for example, several GHz per second. The plurality of wires 41 each have a characteristic impedance of, for example, 100 Ω or 50 Ω. Assume here that a length of each of the plurality of wires 41, i.e., a distance between the radio IC 31 and the radio IC 32 is W2.

The radio IC 32 modulates the baseband signal obtained by the radio IC 31 and converts, into a second RF signal, the baseband signal modulated. The radio IC 31 modulates the baseband signal obtained by the radio IC 32 and converts, into a second RF signal, the baseband signal modulated. Such a second RF signal can have a frequency identical to or different from a frequency of the first RF signal, the second RF signal having been converted from the baseband signal, the baseband signal having been converted from the first RF signal. By causing the second RF signal and the first RF signal to have respective different frequencies, it is possible to alleviate the fear that the first RF signal and the second RF signal may be received in a mixed manner.

The transmitting antennas 51 and 52 are each provided on the substrate 11 in a form of a pattern made of metal. The transmitting antenna 51, which is electrically connected with the radio IC 32, converts, into a second electromagnetic wave, the second RF signal obtained by the radio IC 32 (emits, into a space, the second RF signal obtained by the radio IC 32). The transmitting antenna 52, which is electrically connected with the radio IC 31, converts, into a second electromagnetic wave, the second RF signal obtained by the radio IC 31. For simple illustration, in Fig. 1, the transmitting antennas 51 and 52 are each a pattern which is rectangular when viewed from above. Note, however, that neither of the transmitting antennas 51 and 52 is particularly limited in shape. Note also that the transmitting antennas 51 and 52 each can be provided on not only the front surface of the substrate 11 but also the back surface of the substrate 11 or the inner layer of the substrate 11.

In an operation carried out in a case where the receiving antenna 21 receives the first electromagnetic wave, the radio IC 31 corresponds to a "first radio IC" recited in Claims, and the radio IC 32 corresponds to a "second radio IC" recited in Claims. In contrast, in an operation carried out in a case where the receiving antenna 22 receives the first electromagnetic wave, the radio IC 32 corresponds to the "first radio IC" recited in Claims, and the radio IC 31 corresponds to the "second radio IC" recited in Claims.

The receiving antenna 21 and the transmitting antenna 51 are preferably directional antennas having respective different maximum gain directions. Alternatively, the receiving antenna 21 and the transmitting antenna 51 are preferably directional antennas having respective adjustable maximum gain directions. This makes it easy to clearly determine (i) an angle at which the receiving antenna 21 receives an electromagnetic wave and (ii) an angle at which the transmitting antenna 51 transmits an electromagnetic wave. Similarly, the receiving antenna 22 and the transmitting antenna 52 are preferably directional antennas having respective different maximum gain directions. Alternatively, the receiving antenna 22 and the transmitting antenna 52 are preferably directional antennas having respective adjustable maximum gain directions. This makes it easy to clearly determine (i) an angle at which the receiving antenna 22 receives an electromagnetic wave and (ii) an angle at which the transmitting antenna 52 transmits an electromagnetic wave. Examples of a directional antenna having an adjustable maximum gain direction include a phased array antenna. According to an array antenna, a main beam direction of a radiated electromagnetic wave, which is obtained by superimposing electromagnetic waves radiated from respective antenna elements, can be changed by controlling a time delay imparted to an RF signal supplied to each of the antenna elements. The phased array antenna is an array antenna having such a beam forming function.

The control IC 6 is provided on the substrate 11. The control IC 6 controls the radio ICs 31 and 32. The control IC 6 controls, for example, (i) a frequency of an output signal of each of the radio ICs 31 and 32 and (ii) a level (electric power) of the output signal.

The edge connector 7 is a connector provided at an end in the longer side direction of the substrate 11. The edge connector 7 is connected with the radio ICs 31 and 32 and the control IC 6. It is possible to supply a power supply voltage to the radio IC 31 from a power source (not illustrated), provided on an outside of the radio relay device 201, via a terminal of the edge connector 7, which terminal is connected with the radio IC 31. It is possible to supply a power supply voltage to the radio IC 32 from the power source (not illustrated), provided on the outside of the radio relay device 201, via a terminal of the edge connector 7, which terminal is connected with the radio IC 32. It is possible to supply a power supply voltage to the control IC 6 from the power source (not illustrated), provided on the outside of the radio relay device 201, via a terminal of the edge connector 7, which terminal is connected with the control IC 6. Furthermore, it is possible to supply a signal to the control IC 6 from a signal source (not illustrated), provided on the outside of the radio relay device 201, via a terminal of the edge connector 7, which terminal is connected with the control IC 6. The edge connector 7 is connected with the radio ICs 31 and 32 and the control IC 6 via wires provided on the substrate 11. These wires are provided on any of layers of the multilayer structure (described earlier) of the substrate 11. Instead of providing the edge connector 7 to the substrate 11, it is alternatively possible to solder, to the substrate 11, a plurality of terminals constituting a connector.

The reinforcing plate 81 is provided so as to extend over a first side of the substrate 11 which first side is opposite from a second side of the substrate 11 on which second side the receiving antenna 21, the radio IC 31, the transmitting antenna 52, and the control IC 6 are provided. The reinforcing plate 81 reinforces a region 91 of the substrate 11 in which region 91 the receiving antenna 21, the radio IC 31, and the transmitting antenna 52, and the control IC 6 are provided.

The reinforcing plate 82 is provided so as to extend over the first side of the substrate 11 which first side is opposite from the second side of the substrate 11 on which second side the receiving antenna 22, the radio IC 32, and the transmitting antenna 51 are provided. The reinforcing plate 82 reinforces a region 92 of the substrate 11 in which region 92 the receiving antenna 22, the radio IC 32, and the transmitting antenna 51 are provided.

The reinforcing plate 83 is provided on the first side of the substrate 11 which first side is opposite from the second side of the substrate 11 on which second side the edge connector 7 is provided. The reinforcing plate 83 reinforces a region 93 of the substrate 11 in which region 93 the edge connector 7 is provided.

The reinforcing plates 81 to 83 are so hard as to be unbendable. The reinforcing plates 81 to 83 each can be made of, for example, a resinous plate, a metallic plate, or a metallic solid pattern.

In the operation carried out in a case where the receiving antenna 21 receives the first electromagnetic wave, the reinforcing plate 81 corresponds to a "first reinforcing plate" recited in Claims, and the reinforcing plate 82 corresponds to a "second reinforcing plate" recited in Claims. In contrast, in the operation carried out in a case where the receiving antenna 22 receives the first electromagnetic wave, the reinforcing plate 82 corresponds to the "first reinforcing plate" recited in Claims, and the reinforcing plate 81 corresponds to the "second reinforcing plate" recited in Claims.

According to the radio relay device 201, a baseband signal having a lower frequency than the first RF signal and the second RF signal is transmitted via each of the plurality of wires 41 via which the radio IC 31 and the radio IC 32 are connected with each other. This makes it possible to prevent or reduce a transmission loss of an electric signal in the plurality of wires 41. Specifically, the radio relay device 201 can further prevent or reduce an influence of a transmission loss of an electromagnetic wave than the radio relay device disclosed in Patent Literature 1. No electromagnetic wave is transmitted via a part of the plurality of wires 41 via which part the baseband signal is transmitted. Thus, in such a case, an apparent electromagnetic wave loss is further prevented or reduced in the radio relay device 201 than in a case where an electromagnetic wave is transmitted via the part of the plurality of wires 41 via which part the baseband signal is transmitted.

According to the radio relay device 201, the radio IC 31 does not need to carry out a decoding process for decoding the first RF signal into a radio signal, and the radio IC 32 does not need to carry out an encoding process for encoding the radio signal again into the second RF signal. Thus, as compared with the radio relay device disclosed in Patent Literature 2, the radio relay device 201 makes it possible to further reduce a time delay which may occur in association with radio communication relay. Since the radio IC 31 and the radio IC 32 do not need to carry out the decoding process and the encoding process, respectively, it is possible to reduce a load on each of the radio IC 31 and the radio IC 32. This allows the radio relay device 201 to reduce cost of the radio IC 31 and the radio IC 32.

As described above, the radio relay device 201 which is operated with use of a microwave or a millimeter wave can achieve a reduction in time delay, which may occur in association with radio communication relay, while preventing or reducing a transmission loss of a radio wave.

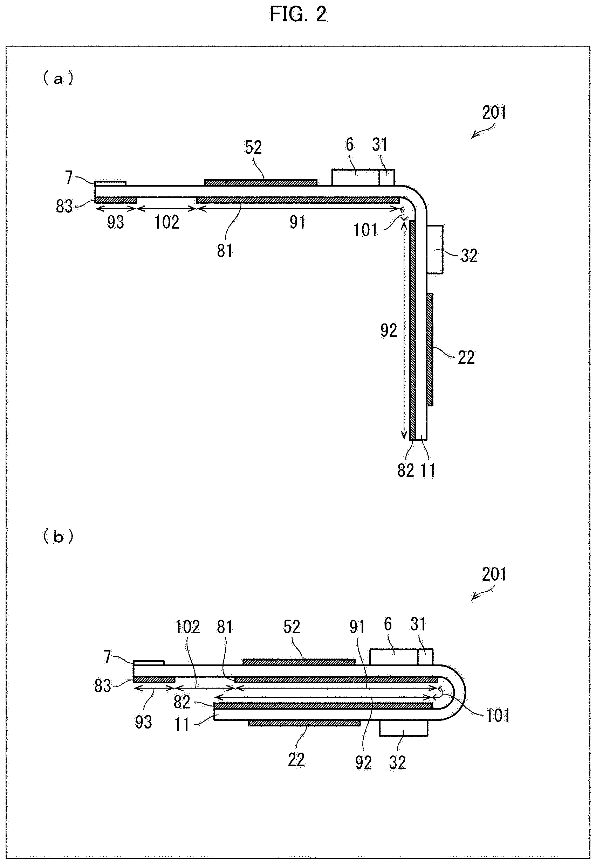

(a) and (b) of Fig. 2 are each a side view illustrating a state in which the radio relay device 201 is bent.

The substrate 11 is a flexible substrate as described earlier. Thus, it is possible to easily bend regions of the substrate 11, which regions are different from the regions 91 to 93, whereas it is difficult to bend the regions 91 to 93. That is, it is possible to bend the substrate 11 so as to cause a ridge in each of (i) a region 101 located between the reinforcing plate 81 (corresponding to the region 91) and the reinforcing plate 82 (corresponding to the region 92) and (ii) a region 102 located between the reinforcing plate 81 and the reinforcing plate 83 (corresponding to the region 93).

In (a) of Fig. 2, the substrate 11 is bent at an angle of 90° in the region 101 in which the ridge is caused. With the configuration, a direction in which the receiving antenna 21 and the transmitting antenna 52 face and a direction in which the receiving antenna 22 and the transmitting antenna 51 face differ from each other by 90°. In this case, the first electromagnetic wave received by the receiving antenna 21 is bent at 90° by the radio relay device 201 and then transmitted from the transmitting antenna 51 in a form of the second electromagnetic wave. In this case, similarly, the first electromagnetic wave received by the receiving antenna 22 is bent at 90° by the radio relay device 201 and then transmitted from the transmitting antenna 52 in the form of the second electromagnetic wave.

In (b) of Fig. 2, the substrate 11 is bent at an angle of 180° in the region 101 in which the ridge is caused. With the configuration, a direction in which the receiving antenna 21 and the transmitting antenna 52 face and a direction in which the receiving antenna 22 and the transmitting antenna 51 face differ from each other by 180°. In this case, the first electromagnetic wave received by the receiving antenna 21 is transmitted from the transmitting antenna 51 in the form of the second electromagnetic wave without being bent by the radio relay device 201. In this case, similarly, the first electromagnetic wave received by the receiving antenna 22 is transmitted from the transmitting antenna 52 in the form of the second electromagnetic wave without being bent by the radio relay device 201.

The radio relay device 201 easily allows a direction of a normal to the region 91 in which the receiving antenna 21 is provided and a direction of a normal to the region 92 in which the transmitting antenna 51 is provided to differ from each other. Thus, the radio relay device 201 easily allows a maximum gain direction of the receiving antenna 21 and a maximum gain direction of the transmitting antenna 51 to be adjusted to respective any directions. Note that the substrate 11 can alternatively be bent at an angle different from 90° or 180° in the region 101 in which the ridge is caused.

Furthermore, the reinforcing plate 81 makes it possible to prevent parts of the substrate 11 which parts are located directly below the receiving antenna 21, the radio IC 31, the transmitting antenna 52, and the control IC 6, respectively, from being bent. Moreover, the reinforcing plate 82 makes it possible to prevent parts of the substrate 11 which parts are located directly below the receiving antenna 22, the radio IC 32, and the transmitting antenna 51, respectively, from being bent. This makes it possible to prevent characteristics of the receiving antennas 21 and 22, characteristics of the radio ICs 31 and 32, characteristics of the transmitting antennas 51 and 52, and characteristics of the control IC 6 from being unexpectedly changed by bending of the substrate 11. Further, the reinforcing plate 83 makes it possible to prevent a part of the substrate 11 which part is located directly below the edge connector 7 from being bent.

Note that an angle at which to bend the substrate 11 in the region 102 in which the ridge is caused can also be arbitrarily set. This makes it possible to freely change a direction of the edge connector 7, so that a wire, for example can be more freely connected to the edge connector 7.

In order to protect the radio relay device 201 and reduce the fear that memory of the shape of the radio relay device 201 which has been bent as described earlier may be suppressed, it is preferable to use the radio relay device 201 which is held in, for example, a resinous clamshell case (not illustrated). In this case, the above case preferably has an opening provided on a path for the first electromagnetic wave, or is preferably made of a material which easily transmits therethrough an electromagnetic wave having a wavelength of the first electromagnetic wave. Same applies to the second electromagnetic wave.

Furthermore, in order to retain memory of the shape of the radio relay device 201 which has been bent as described earlier, it is possible to, for example, attach, to a back surface of the radio relay device 201, a jig (not illustrated) having a desired shape.

Moreover, in order to achieve an electromagnetic shield and/or mechanical reinforcement, it is possible to cover, by a metallic cover (not illustrated), the radio ICs 31 and 32, the control IC 6, and an area around the radio ICs 31 and 32 and the control IC 6.

### Embodiment 2

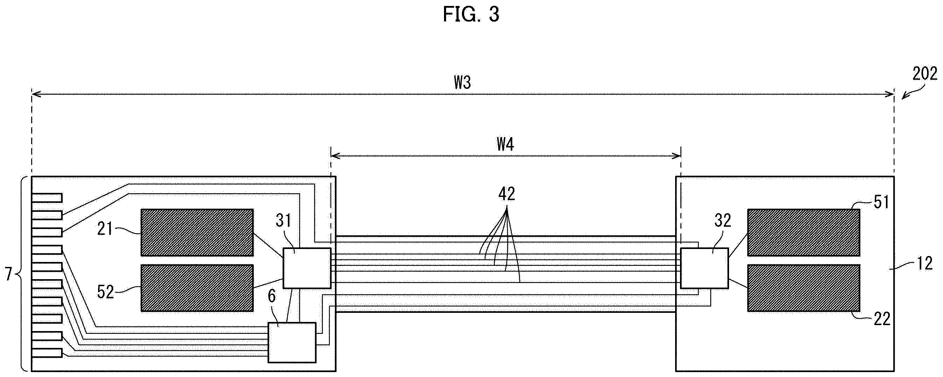

Fig. 3 is a plan view schematically illustrating a configuration of a radio relay device 202 in accordance with Embodiment 2 of the present invention. Note that, for convenience, members having functions identical to those of the respective members described in Embodiment 1 are given respective identical reference signs, and a description of those members is omitted here.

The radio relay device 202 illustrated in Fig. 3 differs from the radio relay device 201 Fig. 1 in that the radio relay device 202 is configured to include a substrate 12 instead of the substrate 11 and include a plurality of wires 42 instead of the plurality of wires 41. The substrate 12 and the plurality of wires 42 are identical in function to the substrate 11 and the plurality of wires 41, respectively, except for the points described below.

W3, which is a length of the substrate 12, as measured in a longer side direction thereof, is longer than W1, which is the length of the substrate 11, as measured in the longer side direction thereof. W4, which is a length of each of the plurality of wires 42 of the substrate 12, is longer than W2, which is the length of each of the plurality of wires 41 of the substrate 11.

A distance between a receiving antenna 21 and a transmitting antenna 51 and a distance between a receiving antenna 22 and a transmitting antenna 52 are longer in the radio relay device 202 than in the radio relay device 201.

Note that it is difficult for an electromagnetic wave having a frequency in a millimeter wave band to be transmitted through a wall and a door. Thus, for example, in order for (i) a base station provided in a corridor and (ii) at least one terminal device provided in a room to communicate with each other over a wall or a door with use of an electromagnetic wave having a frequency in a millimeter wave band, it is necessary to relay the electromagnetic wave. For example, the radio relay device 202 which is provided so as to pass through a space above the door can relay an electromagnetic wave between the base station (corridor side) and the at least one terminal device (room side). That is, the radio relay device 202 is useful for the base station and the at least one terminal device to communicate with each other over the wall or the door. Furthermore, in a case where the at least one terminal device is a single fixed terminal device, each antenna provided on the terminal device side of the radio relay device 202 is preferably an antenna which is highly directional and faces toward the terminal device. In contrast, in a case where the at least one terminal device comprises a plurality of terminal devices or includes a mobile terminal device, each antenna provided on the terminal device side of the radio relay device 202 is preferably an antenna which is moderately directional.

According to the radio relay device 202, the length W4 can be made longer in accordance with a purpose for which the radio relay device 202 is used. Note, however, that attention should be paid because the length W4 which is too long causes an electric signal to be greatly attenuated in each of the plurality of wires 42. In a case where a base material of the substrate 12 is a polyimide and a baseband signal of 3 GHz is transmitted via, for example, a microstrip line, a transmission loss of 2 dB to 3 dB occurs per 10 cm. As compared with the substrate 12 whose base material is a polyimide, the substrate 12 whose base material is an LCP makes it possible to achieve a wire in which a transmission loss is smaller. This is because the substrate 12 whose base material is an LCP has a smaller dielectric constant and a smaller dielectric dissipation factor than the substrate 12 whose base material is a polyimide.

### [Example of use]

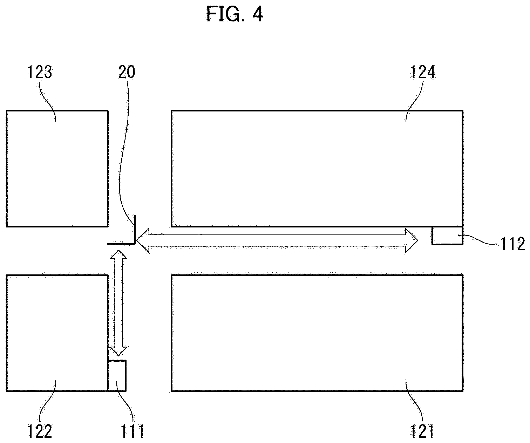

Fig. 4 is a conceptual diagram showing an example of use of a radio relay device 20 in accordance with an embodiment of the present invention.

The radio relay device 20 relays an electromagnetic wave between a radio master unit 111 and a radio slave unit 112. The radio relay device 20 can be the radio relay device 201 illustrated in Fig. 1 or the radio relay device 202 illustrated in Fig. 3.

The radio master unit 111 and the radio slave unit 112 have respective functions of being capable of communicating with each other via an electromagnetic wave having a frequency in, for example, a millimeter wave band. Note, however, that in Fig. 4, the radio master unit 111 and the radio slave unit 112 are provided in a positional relationship in which due to presence of buildings 121 to 124, in particular, presence of the building 121, an electromagnetic wave emitted by one of the radio master unit 111 and the radio slave unit 112 does not reach the other one of the radio master unit 111 and the radio slave unit 112 in a case where the radio relay device 20 is not used.

The radio relay device 20 guides a first electromagnetic wave, which is an electromagnetic wave emitted by one of the radio master unit 111 and the radio slave unit 112, to the other one of the radio master unit 111 and the radio slave unit 112 in a form of a second electromagnetic wave. This allows the radio relay device 20 to relay an electromagnetic wave between the radio master unit 111 and the radio slave unit 112.

Aspects of the present invention can also be expressed as follows:
A radio relay device (201, 202) in accordance with an aspect of the present invention includes: a substrate (11, 12); a receiving antenna (21, 22), provided on the substrate (11, 12), for converting a first electromagnetic wave into a first radio frequency (RF) signal; a first radio integrated circuit (IC) (31, 32), provided on the substrate (11, 12), for converting, into a baseband signal, the first RF signal which has been obtained via the receiving antenna (21, 22); a second radio IC (32, 31), provided on the substrate (11, 22), for converting, into a second RF signal, the baseband signal which has been obtained by the first radio IC (31, 32); and a transmitting antenna (51, 52), provided on the substrate (11, 12), for converting, into a second electromagnetic wave, the second RF signal which has been obtained by the second radio IC (32, 31), the first radio IC (31, 32) and the second radio IC (32, 31) being connected with each other via a wire (41, 42) on the substrate (11, 12) so that the baseband signal is transmitted via the wire (41, 42).

With the configuration, a baseband signal having a lower frequency than the first RF signal and the second RF signal is transmitted via the wire via which the first radio IC and the second radio IC are connected with each other. Thus, the radio relay device which is applied to radio communication carried out with use of a microwave or a millimeter wave can further prevent or reduce a transmission loss of an electromagnetic wave in the wire than the radio relay device disclosed in Patent Literature 1.

Furthermore, with the configuration, the first radio IC does not need to carry out a decoding process for decoding the first RF signal into a data signal, and the second radio IC does not need to carry out an encoding process for encoding the data signal into the second RF signal. Thus, as compared with the radio relay device disclosed in Patent Literature 2, the radio relay device in accordance with an aspect of the present invention makes it possible to further reduce a time delay which may occur in association with radio communication relay. Since the first radio IC and the second radio IC do not need to carry out the decoding process and the encoding process, respectively, it is possible to reduce a load on each of the first radio IC and the second radio IC, and consequently to reduce cost of the first radio IC and the second radio IC.

As described earlier, according to the present radio relay device which is applied to radio communication carried out with use of a microwave or a millimeter wave, a time delay which may occur in association with radio communication relay can be reduced while a transmission loss of a radio wave is prevented or reduced.

The radio relay device (201, 202) in accordance with an aspect of the present invention is preferably configured such that the substrate (11, 12) is a flexible substrate and is bent so that the receiving antenna (21, 22) and the transmitting antenna (51, 52) face in respective different directions.

With the configuration, a receiving antenna and a transmitting antenna can have respective different maximum gain directions. This easily allows a maximum gain direction of the receiving antenna and a maximum gain direction of the transmitting antenna to be adjusted to respective any directions.

A radio relay device (201, 202) in accordance with an aspect of the present invention is preferably configured to further include: a first reinforcing plate (81, 82) which reinforces a first region of the substrate (11, 12) in which first region the receiving antenna (21, 22) and the first radio IC (31, 32) are provided; and a second reinforcing plate (82, 81) which reinforces a second region of the substrate (11, 12) in which second region the transmitting antenna (51, 52) and the second radio IC (32, 31) are provided, the substrate (11, 22) being bent so as to cause a ridge between the first reinforcing plate (81, 82) and the second reinforcing plate (82, 81).

The configuration makes it possible to prevent parts of the substrate which parts are located directly below the receiving antenna, the first radio IC, the transmitting antenna, and the second radio IC, respectively, from being bent. Thus, it is possible to prevent characteristics of the receiving antenna, characteristics of the first radio IC, characteristics of the transmitting antenna, and characteristics of the second radio IC from being made unstable by a stress which occurs in association with bending of the substrate.

The radio relay device in accordance with an aspect of the present invention is preferably configured such that the receiving antenna (21, 22) and the transmitting antenna (51, 52) are directional antennas having respective different maximum gain directions.

With the configuration, in a case where (i) a relative positional relationship between a radio relay device and a base station and (ii) a relative positional relationship between the radio relay device and a terminal are determined in advance, radio communication between the base station and the terminal can be carried out with higher efficiency by providing the radio relay device so that a receiving antenna has a maximum gain direction facing the base station and a transmitting antenna has a maximum gain direction facing the terminal.

The radio relay device (201, 202) in accordance with an aspect of the present invention is preferably configured such that the receiving antenna (21, 22) and the transmitting antenna (51, 52) are directional antennas having respective adjustable maximum gain directions.

With the configuration, also in a case where (i) a relative positional relationship between a radio relay device and a base station and/or (ii) a relative positional relationship between the radio relay device and a terminal are/is changed after the radio relay device is provided, a maximum gain direction of a receiving antenna can be easily adjusted so as to face the base station, and a maximum gain direction of a transmitting antenna can be easily adjusted so as to face the terminal.

The radio relay device (201, 202) in accordance with an aspect of the present invention is preferably configured such that a base material of the substrate (11, 12) is a liquid crystal polymer.

A transmission path constituted by a wire which is provided on a surface or an inner layer of a liquid crystal polymer makes it possible to prevent or reduce, in a resin material, a transmission loss which occurs during transmission of an electric signal having a frequency in the range of several GHz to several ten GHz. Furthermore, in a case where a radio relay device which is applied to radio communication carried out with use of a millimeter wave band (e.g., a 60 GHz band), a baseband signal preferably has a frequency of approximately several GHz. Thus, with the configuration, the radio relay device in accordance with an aspect of the present invention can be suitably used for radio communication carried out with use of a millimeter wave band (e.g., a 60 GHz band).

The present invention is not limited to the embodiments, but can be altered by a skilled person in the art within the scope of the claims. The present invention also encompasses, in its technical scope, any embodiment derived by combining technical means disclosed in differing embodiments.

### Reference Signs List

11, 12 Substrate
21, 22 Receiving antenna
31, 32 Radio IC (first radio IC (second radio IC), second radio IC (first radio IC))
41, 42 Wire
51, 52 Transmitting antenna
81, 82 Reinforcing plate (first reinforcing plate (second reinforcing plate), second reinforcing plate (first reinforcing plate))
83 Reinforcing plate
20, 201, 202 Radio relay device

## Claims

1. A radio relay device comprising:
a substrate;
a receiving antenna, provided on the substrate, for converting a first electromagnetic wave into a first RF signal;
a first radio IC, provided on the substrate, for converting, into a baseband signal, the first RF signal which has been obtained via the receiving antenna;
a second radio IC, provided on the substrate, for converting, into a second RF signal, the baseband signal which has been obtained by the first radio IC; and
a transmitting antenna, provided on the substrate, for converting, into a second electromagnetic wave, the second RF signal which has been obtained by the second radio IC,
the first radio IC and the second radio IC being connected with each other via a wire on the substrate so that the baseband signal is transmitted via the wire.

2. The radio relay device as set forth in claim 1, wherein the substrate is a flexible substrate and is bent so that the receiving antenna and the transmitting antenna face in respective different directions.

3. A radio relay device as set forth in claim 2, further comprising:
a first reinforcing plate which reinforces a first region of the substrate in which first region the receiving antenna and the first radio IC are provided; and
a second reinforcing plate which reinforces a second region of the substrate in which second region the transmitting antenna and the second radio IC are provided,
the substrate being bent so as to cause a ridge between the first reinforcing plate and the second reinforcing plate.

4. The radio relay device as set forth in any one of claims 1 through 3, wherein the receiving antenna and the transmitting antenna are directional antennas having respective different maximum gain directions.

5. The radio relay device as set forth in any one of claims 1 through 3, wherein the receiving antenna and the transmitting antenna are directional antennas having respective adjustable maximum gain directions.

6. The radio relay device as set forth in any one of claims 1 through 5, wherein a base material of the substrate is a liquid crystal polymer.
